# EUROPÄISCHE PATENTSCHRIFT

(11) **EP 0 957 399 B1**
(45) Veröffentlichungstag und Bekanntmachung des Hinweises auf die Patenterteilung: **18.02.2004**
(21) Anmeldenummer: 99107110.1
(22) Anmeldetag: 12.04.1999
(51) Int. Cl.: G03F 7/004, G03F 7/075, G03F 7/039

(54) **Strahlungsempfindliches Gemisch und dessen Verwendung**
Radiation-sensitive composition and its use
Composition sensible aux radiations et son utilisation

(30) Priorität: 24.04.1998 DE 19818447
(43) Veröffentlichungstag der Anmeldung: 17.11.1999
(73) Patentinhaber: Infineon Technologies AG, 80506 München (DE)
(72) Erfinder: Hien, Stefan Dr., 91058 Erlangen (DE); Sebald, Michael Dr., 91085 Weisendorf (DE)
(74) Vertreter: Maiwald, Walter, Dr. Dipl.-Chem.

(56) Entgegenhaltungen:
- EP-A- 0 494 383
- EP-A- 0 645 679
- EP-A- 0 689 098
- EP-A- 0 789 278
- WO-A-97/14079
- US-A- 5 482 816

## Beschreibung

Die Erfindung betrifft ein strahlungsempfindliches Gemisch sowie die Verwendung dieses strahlungsempfindlichen Gemisches.

Bei der Strukturierung von Halbleiterbauelementen im großtechnischen Maßstab werden lichtempfindliche Mischungen aus einem Basispolymer und einer photoaktiven (strahlungsempfindlichen) Komponente, sogenannte Photolacke bzw. Photoresists, verwendet. Dabei wird zunächst eine Schicht des Photolacks auf dem zu strukturierenden Substrat hergestellt und in diese Schicht mit einem geeigneten Belichtungsgerät das Bild einer Maske projiziert. Durch photochemische Veränderung der photoaktiven Komponente in der Schicht entsteht ein latentes Bild. Je nach Tonalität des Photolacksystems (positiv oder negativ) werden dann, gegebenenfalls nach einem Temperschritt, die belichteten oder die unbelichteten Bereiche des latenten Bildes durch einen geeigneten Entwickler herausgelöst (entwickelt). Die so erhaltenen Reliefstrukturen in der Photolackschicht zeigen das positive bzw. negative Abbild der Maske und dienen ihrerseits als ätzresistente Maske zur Strukturierung des Substrats mittels eines geeigneten Ätzmediums. Eine wichtige Voraussetzung für Photolacke mit guten Strukturierungseigenschaften ist unter anderem eine hohe Transparenz des Basispolymers bei der Belichtungswellenlänge, wie dies beispielsweise für anhydridgruppenhaltige Polymere in einem Positiv-Photolack in EP 0 388 484 A1 beschrieben ist.

In Proc. SPIE Vol. 2724 (1996), Seiten 296 bis 307, wird ein Basispolymer mit 1,2-Dicarbonsäurehalbestereinheiten für die Verwendung in wäßrig prozessierbaren Negativ-Photolacken beschrieben. Dabei wird eine Schicht, bestehend aus dem Polymer und einer Photosäure, d.h. einer Verbindung, die bei Belichtung eine starke Säure freisetzt, nach einer strukturierenden Belichtung einem Temperschritt unterworfen, wobei in den belichteten Bereichen säurekatalysiert Anhydridgruppen gebildet werden. Bei der wäßrigen Entwicklung werden dann selektiv die unbelichteten Bereiche herausgelöst. Die Erzeugung von Positiv-Strukturen ist mit Polymeren der genannten Art allerdings nicht möglich, da die eingesetzten Esterreste säurekatalytisch nicht in freie 1,2-Dicarbonsäurebausteine überführt werden können.

Aufgrund von Unebenheiten und hoher Reflektivität von Halbleitersubstraten wird bei der Feinststrukturierung die Zweilagentechnik verwendet. Dabei wird auf dem Substrat zunächst eine planarisierende und absorbierende Polymerschicht erzeugt, die als Substrat für eine dünne Photolackschicht (Topresist) dient. Diese Photolackschicht kann unter idealen Belichtungsbedingungen (planarer und lichtabsorbierender Untergrund, dünne Schicht innerhalb der Tiefenschärfe gewährleistet scharfe Abbildung) belichtet werden. Nach der Entwicklung werden positive bzw. negative Strukturen bei höchster Auflösung im Topresist erhalten. Diese Strukturen werden, wie in EP 0 395 917 A2 beschrieben, in einem separaten naßchemischen Schritt silyliert, d.h. über ein siliciumhaltiges reaktives Agens wird chemisch Silicium an das Basispolymer gebunden; gleichzeitig erfahren die Strukturen eine einstellbare laterale Aufweitung. Dadurch ist gewährleistet, daß die Topresist-Strukturen in einem anisotropen Sauerstoffplasma in die planarisierende Polymerschicht übertragen werden können und Strukturen mit hohem Aspektverhältnis und höchster Auflösung erhalten werden. Eine wichtige Voraussetzung für einen silylierfähigen Topresist ist dabei die Verwendung eines Basispolymers mit reaktiven Gruppen, wie dies beispielsweise für anhydridgruppenhaltige Polymere in EP 0 388 484 A1 beschrieben ist.

Die sogenannte TSI-Technik (Top Surface Imaging) besitzt dieselben Vorzüge wie die Zweilagentechnik, bietet aber zusätzlich den Vorteil einer vereinfachten Prozeßführung.

Dabei wird auf dem Halbleitersubstrat zunächst eine lichtempfindliche Photolackschicht aufgebracht. Bei der strukturierenden Belichtung wird dann lediglich in der Oberfläche (top surface) ein latentes Bild erzeugt. Dieses Bild wird direkt nach der Belichtung, je nach Tonalität, in den belichteten (negativ) oder unbelichteten (positiv) Bereichen silyliert, wie es beispielsweise in EP 0 394 740 A2 und EP 0 492 256 A1 beschrieben ist. Die eigentliche Entwicklung erfolgt in einem anisotropen Sauerstoffplasma, wobei Strukturen mit hohem Aspektverhältnis und höchster Auflösung erhalten werden. Eine wichtige Voraussetzung für einen silylierfähigen Photolack ist die Verwendung eines Basispolymers mit reaktiven Gruppen, wie dies beispielsweise für anhydridgruppenhaltige Polymere in EP 0 388 484 A1 beschrieben ist.

Bei den sogenannten chemisch verstärkten Photolacken (siehe beispielsweise US-PS 4 491 628) wird mit einer geringen Belichtungsdosis in der Photolackschicht aus einem ionischen oder nicht-ionischen photoaktiven Säurebildner photochemisch eine geringe Menge einer Säure erzeugt. Diese Säure bewirkt bei einem nachfolgenden Temperschritt (PEB = Post Exposure Bake) die katalytische Abspaltung einer Schutzgruppe am Polymer und damit den für die Entwicklung nötigen Wechsel von hydrophob nach hydrophil. Durch Entwicklung in einem alkalischen Entwickler werden die belichteten hydrophilen Bereiche herausgelöst und man erhält ein positives Abbild der Maske, während bei Verwendung eines organischen Lösemittels als Entwickler die unbelichteten hydrophoben Bereiche herausgelöst werden und ein negatives Bild erhalten wird. Als säurelabile Schutzgruppen werden insbesondere tert.-Butoxycarbonyl-maleinimidgruppen (EP 0 492 253 A1), tert.-Butylestergruppen (EP 0 494 383 A1) und tert.-Butoxycarbonyloxystyrolgruppen (US-PS 4 491 628) eingesetzt.

Bei den bisher bekannten Photoresistmaterialien, d.h. strahlungsempfindlichen Gemischen, werden somit mit wäßrig-alkalischen Entwicklern entweder die belichteten oder die unbelichteten Bereiche herausgelöst. Das entsprechende Negativbild kann durch Verwendung organischer Lösemittel erzeugt werden. Diese Option ist jedoch nicht praktikabel, da hiermit bei der Scheibenfertigung ein großer sicherheitstechnischer Aufwand verbunden ist. Für die zweifache Tonalität (dual tonality) eines Resistmaterials sind bislang somit zwei verschiedene Entwickler (wäßrig oder organisch) erforderlich.

Aufgabe der Erfindung ist es, ein strahlungsempfindliches Gemisch bereitzustellen, das - nach der Bestrahlung und der thermischen Behandlung - einerseits wäßrig entwickelt werden kann und andererseits entweder ein negatives oder ein positives Bild ergibt. Dabei sollen ferner insbesondere solche Strukturen entstehen, die in einem Folgeschritt silyliert und/oder mit aminofunktionellen Verbindungen modifiziert werden können.

Dies wird erfindungsgemäß durch ein strahlungsempfindliches Gemisch erreicht, das folgende Komponenten enthält:
- ein filmbildendes Polymer, das einen säurelabilen, hydrolysestabilen Polymerbaustein (A) folgender Struktur: 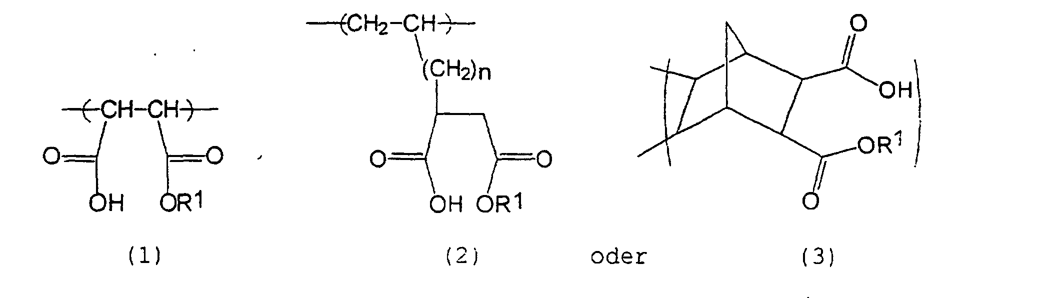 mit einem Anteil von 1 bis 99 Mol-% und einen thermisch stabilen Polymerbaustein (B) folgender Struktur: 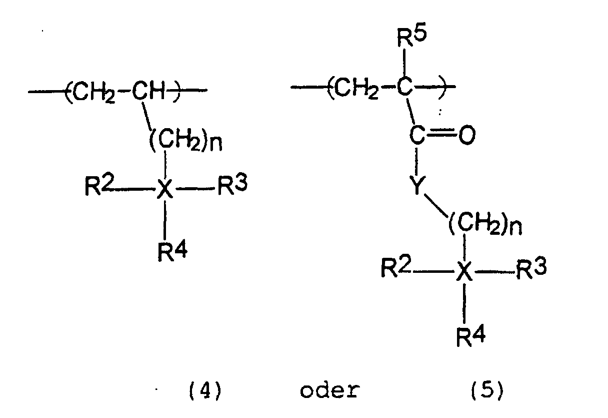 mit einem Anteil von 99 bis 1 Mol-% aufweist,
   wobei folgendes gilt:
   n = 0, 1, 2 oder 3,wobei für die Struktur (5) n = 1, 2 oder 3 ist,
   R¹ ist ein über ein tertiäres C-Atom an das O-Atom gebundener Kohlenwasserstoffrest mit insgesamt 4 bis 10 C-Atomen oder ein 2-Tetrahydrofuranyl- oder 2-Tetrahydropyranylrest,
   R², R³ und R⁴ sind - unabhängig voneinander - C₁- bis C₆-Alkyl oder C₁- bis C₆-Alkoxy, C₆- bis C₁₈-Aryl oder C₆- bis C₁₈-Aryloxy oder Aralkyl mit einer C₆- bis C₁₈-Arylgruppe und einem C₁- bis C₄-Alkylenrest,
   R⁵ ist H oder C₁- bis C₆-Alkyl,
   X ist Si oder Sn,
   Y ist O oder NH;
- eine bei Bestrahlung eine Säure freisetzende strahlungsempfindliche Verbindung;
- ein Lösemittel;
- gegebenenfalls Additive.

Das strahlungsempfindliche Gemisch nach der Erfindung, d.h. der Photolack, besteht aus einer Lösung von mindestens einem Basispolymer mit säurelabilen Gruppen, mindestens einer photoaktiven Verbindung und gegebenenfalls weiteren Zusätzen, d.h. Additiven, in einem gängigen Photolack-Lösemittel, wie Cyclohexanon, Ethyllactat oder Propylenglykol-monomethyletheracetat. Die Besonderheit der säurelabilen Gruppen besteht darin, daß es sich um 1,2-Dicarbonsäurehalbester-Bausteine handelt. Diese Gruppen garantieren eine hohe Haftung auf dem Substrat und erlauben die Erzeugung positiver und negativer Photolackstrukturen.

Es wurde nämlich überraschenderweise gefunden, daß mit dem Photolack nach der Erfindung - in Abhängigkeit von der Art der thermischen Behandlung (Temperung) - entweder negative oder positive Bilder erzeugt werden können (zweifache Tonalität). Das Prinzip besteht dabei darin, daß - ausgehend von einem Material mit mittlerer Löslichkeit (mittlere Polarität) - einerseits eine hydrophobe und andererseits eine hydrophile Resistschicht erhalten wird. Ermöglicht wird dies durch die Verwendung von Photolacken mit säurelabilen Polymeren, die 1,2-Dicarbonsäurehalbester-Gruppierungen besitzen.

Je nach der Prozeßführung entsteht aus der Dicarbonsäurehalbestergruppierung, die insbesondere eine Bernsteinsäure-monotert.-butylester-Gruppe ist, entweder eine Dicarbonsäureoder eine Dicarbonsäureanhydrid-Gruppierung, d.h. eine Bernsteinsäure- oder Bernsteinsäureanhydrid-Struktur. Beide Prozesse können säurekatalysiert durchgeführt werden. In diesem Fall ist die thermische Aktivierungsbarriere deutlich erniedrigt.

Die Dicarbonsäure-modifizierten Polymeren sind in basischen wäßrigen Entwicklern sehr gut löslich, die Anhydridfunktionen dagegen wirken - im Vergleich zum Ausgangsmaterial - lösungshemmend. Dies läßt sich chemisch folgendermaßen erklären: Die Abspaltung der Reste R¹, beispielsweise in Form von Isobuten, führt zur'Dicarbonsäure-Struktureinheit. Dies geht mit einer deutlichen Hydrophobierung einher, die bei der Entwicklung mit (basischen) wäßrigen Lösungsmitteln ein positives Bild bewirkt. Die Cyclisierung zur Anhydridstruktur unter Wasserabspaltung führt zu einer Polaritätsumkehr des Resistmaterials. Auf diese Weise lassen sich mit wäßrigen alkalischen Entwicklern negative Strukturen erzeugen. Durch einen weiteren Temperschritt bei hohen Temperaturen, gegebenenfalls auch in Kombination mit einer Flutbelichtung, läßt sich der Anteil der Anhydridfunktionen im Resist erhöhen und dadurch eine weitere Funktionalisierung, beispielsweise mit aminofunktionellen Verbindungen, erreichen.

Die Prozessierung des Photolacks erfordert lediglich die in einer üblichen Prozeßlinie vorhandenen Geräte. Die Beschichtung des Substrats mit dem Photolack erfolgt durch Aufschleudern und anschließende Trocknung bei einer Temperatur von 100 bis 180°C, typischerweise 120 bis 160°C, innerhalb von 30 bis 240 s auf einer Heizplatte. Temperatur und Zeit werden bei diesem Trocknungsschritt in der Regel so gewählt werden, daß das Basispolymer sich in seiner Zusammensetzung nicht verändert. Es kann aber bereits bei diesem Verfahrensschritt eine thermische Zersetzung des Materials angestrebt werden. Dabei wird in der hydrolysestabilen 1,2-Dicarbonsäurehalbester-Vorstufe ein gewünschter Anhydridgehalt eingestellt.

Nach dem Trocknen erfolgt die Bestrahlung, insbesondere im tiefen UV, beispielsweise 248 nm, gegebenenfalls aber auch bei 193 nm, oder mit Elektronenstrahlen. Anschließend wird die für die Tonalität des Bildes maßgebliche thermische Behandlung (PEB) durchgeführt. Die gewählte PEB-Temperatur und die Zeitdauer entscheiden, ob mit wäßrigen basischen Entwicklern positive oder negative Bilder erhalten werden. Bei niedrigen Temperaturen, d.h. < 140°C, und kurzen Zeiten werden positive Bilder erhalten, da die Generierung der zusätzlichen freien Carbonsäuregruppen am Polymer eine Löslichkeitserhöhung bewirkt. Bei hohen PEB-Temperaturen, d.h. > 140°C, und langen Reaktionszeiten werden negative Bilder erzeugt. Dies resultiert aus der Bildung zusätzlicher Anhydridfunktionen. Im Falle von negativen Bildern werden im Vergleich zu positiven Bildern bei gleicher Entwicklerkonzentration längere Entwicklungszeiten benötigt.

Der Photolack nach der Erfindung weist als strahlungsempfindliche Verbindung vorzugsweise eine ionische oder nicht-ionische Verbindung auf. Die ionische Verbindung ist vorteilhaft ein Oniumsalz, insbesondere ein Iodonium- oder Sulfoniumsalz, bevorzugt mit einem Sulfonat-Anion. Die nicht-ionische Verbindung ist vorteilhaft ein Imidsulfonsäureester, es können beispielsweise aber auch Pyrogallolderivate eingesetzt werden.

Die dem strahlungsempfindlichen Gemisch nach der Erfindung gegebenenfalls zugesetzten Additive können beispielsweise Farbstoffe, Fließmittel, Säurefänger, d.h. basische Verbindungen, oder Stabilisatoren sein.

Polymere der vorstehend genannten Art sind Gegenstand der gleichzeitig eingereichten deutschen Patentanmeldung Nr. 198 18 446.8 - "Filmbildende Polymere". Bei diesen Polymeren ergänzen sich die Anteile an den Polymerbausteinen (A) und (B) zu 100 Mol-%. Der Anteil der Polymeren am Baustein (A) beträgt vorzugsweise 5 bis 50 Mol-%. Der Rest R¹ kann beispielsweise ein tert.-Butylrest -C(CH₃)₃, ein tert. -Pentylrest -C(CH₃)₂-C₂H₅ oder ein 1-Adamantylrest (-C₁₀H₁₅) sein. Ein wesentliches Merkmal des Polymerbausteins (B) ist im übrigen dessen metallischer Bestandteil, d. h. das Vorhandensein von Silicium Si bzw. Zinn Sn.

Die Polymeren können - entsprechend den Struktureinheiten (1) bzw. (2) und (3) - ketten- oder seitenständige 1,2-Dicarbon-1,2-Dicarbonsäurehalbester-Gruppierungen aufweisen. Ein Polymer aus den Bausteinen (A) und (B) mit kettenständigen Gruppierungen kann beispielsweise durch Umsetzung eines Maleinsäureanhydrid-Copolymers mit tert.-Butanol hergestellt werden. Die 1,2-Dicarbonsäure-mono-tert.-butylester-Gruppierungen können aber auch durch Homo- oder Copolymerisation von Fumarsäure- oder Maleinsäure-mono-tert.-butylester in das Polymer eingeführt werden.

Polymere mit seitenständigen 1,2-Dicarbonsäurehalbester-Gruppierungen, d.h. mit Gruppierungen, die nicht direkt an die Polymerhauptkette gebunden sind, sondern außerhalb der Hauptkette liegen, können beispielsweise durch Homopolymerisation von bzw. Copolymerisation mit 1-Alkyl-2-(3-alkylenbernsteinsäureanhydrid)-ethylen und anschließende Umsetzung mit tert.-Butanol oder durch Homopolymerisation von 1-Alkyl-2-(3-alkylen-bernsteinsäure-mono-tert.-butylester)-ethylen erhalten werden. Im Falle der Struktureinheit (3) sind die 1,2-Dicarbonsäurehalbester-Gruppierungen im übrigen über einen Norbornylrest an die Polymerhauptkette gebunden.

Zur Herstellung der Polymeren werden im allgemeinen Monomere für die Bausteine (A) mit elektronenreichen Monomeren für die Bausteine (B) copolymerisiert. Durch die Copolymerisation werden einerseits hohe Polymerausbeuten erreicht, und andererseits können auf diese Weise die physikalischen Eigenschaften der Polymeren eingestellt werden. So kann beispielsweise ein bestimmter Si-Gehalt realisiert werden. Die Polymeren können auch noch einen weiteren thermisch stabilen Polymerbaustein (C) und/oder einen Polymerbaustein (D) aufweisen, welcher reaktive Gruppen besitzt, die eine Nachbehandlung des Polymers erlauben.

Ein Photolack nach der Erfindung mit hoher. Empfindlichkeit im tiefen UV, insbesondere 248 nm, kann beispielsweise durch Lösen eines Copolymers mit 50 Mol-% 1,2-Dicarbonsäure-mono-tert.-butylester-Gruppierungen und 50 Mol-% Allyltrimethylsilan-Gruppierungen zusammen mit Triphenylsulfonium-trifluormethansulfonat (als photoaktiven Säurebildner) in Cyclohexanon erhalten werden.

Anhand von Ausführungsbeispielen soll die Erfindung noch näher erläutert werden (GT = Gewichtsteile).

### Beispiel 1

### Herstellung eines Polymers mit 1,2-Dicarbonsäure-mono-tert.-butylester-Gruppierungen

Eine Lösung von 50 GT eines alternierenden Copolymers aus Maleinsäureanhydrid und Styrol in 50 GT trockenem Tetrahydrofuran wird bei Raumtemperatur unter intensivem Rühren tropfenweise mit 250 GT einer 10 %igen Lösung (GT) von Kalium-tert.-butylat in trockenem Tetrahydrofuran versetzt. Das Reaktionsgemisch dann 30 min auf 50°C erhitzt und danach auf Raumtemperatur abgekühlt. Das entstandene Gel wird mit 25 GT Eisessig versetzt. Die dabei erhaltene klare Lösung wird unter Rühren zu 1000 GT Wasser getropft, der Niederschlag abfiltriert und das farblose Polymerpulver anschließend bei 50°C für 24 Stunden im Vakuum getrocknet.

### Beispiel 2

### Herstellung eines Polymers mit 1,2-Dicarbonsäure-mono-tert.-butylester-Gruppierungen

8 GT tert.-Butyl-fumarat (Herstellung analog J. Heterocyclic Chem. Vol. 32 (1995), seiten 1309 bis 1315) werden zusammen mit 5,7 GT Allyltrimethylsilan und 0,08 GT Azobisisobutyronitril in 15 GT Ethylacetat gelöst. Die Lösung wird 24 Stunden zum Sieden erhitzt und danach auf Raumtemperatur abgekühlt. Durch Eintropfen der Polymerlösung in Petrolether (Siedebereich 60 bis 80°C), anschließende Filtration und Trocknung bei 50°C für 24 Stunden im Vakuum werden 10 GT farbloses Polymerpulver erhalten.

### Beispiel 3

### Herstellung eines hochempfindlichen Photolacks für Belichtung im tiefen UV

7 GT des entsprechend Beispiel 2 hergestellten Polymers werden zusammen mit 1 GT Triphenylsulfonium-trifluormethansulfonat in 92 GT Cyclohexanon gelöst. Die erhaltene Lösung wird dann über ein 0,2 µm-Feinstfilter filtriert. Dabei erhält man eine gebrauchsfertige Lösung eines Photolacks für die Belichtung im tiefen UV, beispielsweise bei 248 oder 193 nm.

### Beispiel 4

### Herstellung eines anhydridgruppenhaltigen Photolacks aus einer hydrolysestabilen Vorstufe

Durch Aufschleudern einer Lösung von 25 GT Novolak in 75 GT Propylenglykol-monomethyletheracetat bei 3500 min⁻¹ und anschließendem Ausheizen bei 230°C/30 min in einem Umluftofen erhält man eine 1 µm dicke lichtabsorbierende Schicht. Auf diese Schicht wird durch Aufschleudern der entsprechend Beispiel 3 hergestellten Photolacklösung bei 4500 min⁻¹ und Trocknen bei 180°C/120 s auf einer Heizplatte eine 0,3 µm dicke lichtempfindliche, anhydridgruppenhaltige Photolackschicht aufgebracht.

### Beispiel 5

### Herstellung von anhydridgruppenhaltigen Positiv-Photolackstrukturen (Zweilagentechnik)

Durch Aufschleudern einer Lösung von 25 GT Novolak in 75 GT Propylenglykol-monomethyletheracetat bei 3500 min⁻¹ und anschließendem Ausheizen bei 230°C/30 min in einem Umluftofen erhält man eine 1 µm dicke lichtabsorbierende Schicht. Auf diese Schicht wird durch Aufschleudern der entsprechend Beispiel 3 hergestellten Photolacklösung bei 4500 min⁻¹ und Trocknen bei 100°C/60 s auf einer Heizplatte eine 0,3 µm dicke lichtempfindliche Photolackschicht aufgebracht. Auf diese Schicht wird dann mittels eines 248 nm-Projektionsbelichtungsgerätes mit einer Dosis von 20 mJ/cm² das Bild einer Maske projiziert, welche Steg/Graben-Strukturen im Raster von 0,5 µm enthält. Anschließend erfolgt eine Temperung auf der Heizplatte bei 130°C/60 s. Die Schicht wird dann mit einem 0,01 N Tetramethylammoniumhydroxid-Entwickler 60 s im Puddleverfahren entwickelt und anschließend bei 190°C/120 s auf der Heizplatte getempert (Anhydridbildung). Es werden 0,3 µm hohe Steg/Graben-Strukturen im Raster von 0,5 µm erhalten.

### Beispiel 6

### Herstellung von anhydridgruppenhaltigen Negativ-Photolackstrukturen (Zweilagentechnik)

Durch Aufschleudern einer Lösung von 25 GT Novolak in 75 GT Propylenglykol-monomethyletheracetat bei 3500 min⁻¹ und anschließendem Ausheizen bei 230°C/30 min in einem Umluftofen erhält man eine 1 µm dicke lichtabsorbierende Schicht. Auf diese Schicht wird durch Aufschleudern der entsprechend Beispiel 3 hergestellten Photolacklösung bei 4500 min⁻¹ und Trocknen bei 100°C/60 s auf einer Heizplatte eine 0,3 µm dicke lichtempfindliche Photolackschicht aufgebracht. Auf diese Schicht wird dann mittels eines 248 nm-Projektionsbelichtungsgerätes mit einer Dosis von 20 mJ/cm² das Bild einer Maske projiziert, welche steg/Graben-Strukturen im Raster von 0,5 µm enthält. Anschließend erfolgt eine Temperung auf der Heizplatte bei 170°C/60 s (Anhydridbildung im Hellfeld). Die Schicht wird dann mit einem 0,26 N Tetramethylammoniumhydroxid-Entwickler 60 s im Puddleverfahren entwickelt. Es werden 0,3 µm hohe Steg/Graben-Strukturen im Raster von 0,5 µm erhalten.

### Beispiel 7

### Herstellung silylierter, trockenentwickelter Strukturen (Zweilagentechnik)

Entsprechend Beispiel 5 bzw. 6 erzeugte Photolackstrukturen werden mit einer 2,5 %igen Lösung (GT) von Bisamino-oligodimethylsiloxan in einem Gemisch aus 1 GT Wasser und 5 GT Isopropanol während 60 s im Puddleverfahren silyliert und bei 100°C/60 s auf einer Heizplatte getrocknet. Die silylierten Strukturen werden dann in einer Plasmaätzanlage mittels eines anisotropen Sauerstoffplasmas in die darunter befindliche lichtabsorbierende Schicht übertragen. Es werden 0,3 µm hohe Steg/Graben-Strukturen mit steilen Flanken im Raster von 0,5 µm erhalten.

## Patentansprüche

1. Strahlungsempfindliches Gemisch, das folgende Komponenten enthält:
- ein filmbildendes Polymer, das einen säurelabilen, hydrolysestabilen Polymerbaustein (A) folgender Struktur: 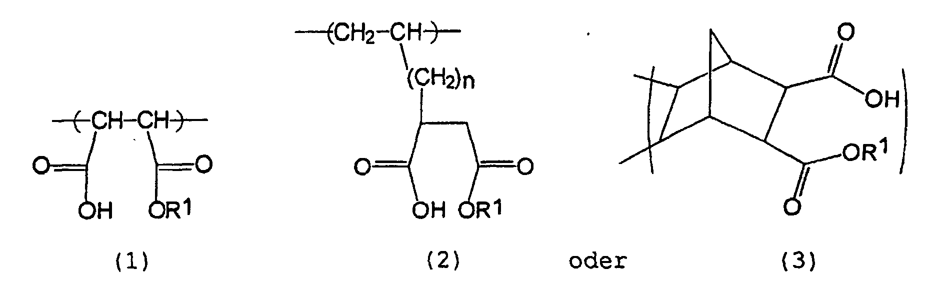 mit einem Anteil von 1 bis 99 Mol-% und einen thermisch stabilen Polymerbaustein (B) folgender Struktur: 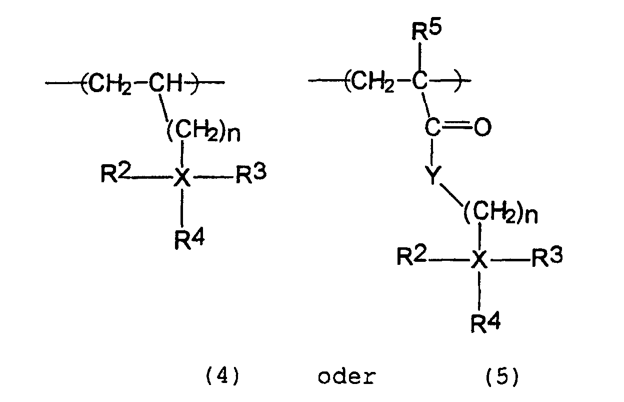 mit einem Anteil von 99 bis 1 Mol-% aufweist,
wobei folgendes gilt:
n = 0, 1, 2 oder 3, wobei für die Struktur (5) n = 1,2 oder 3 ist,
R¹ ist ein über ein tertiäres C-Atom an das O-Atom gebundener Kohlenwasserstoffrest mit insgesamt 4 bis 10 C-Atomen oder ein 2-Tetrahydrofuranyl- oder 2-Tetrahydropyranylrest,
R², R³ und R⁴ sind - unabhängig voneinander - C₁- bis C₆-Alkyl oder C₁- bis C₆-Alkoxy, C₆- bis C₁₈-Aryl oder C₆- bis C₁₈-Aryloxy oder Aralkyl mit einer C₆- bis C₁₈-Arylgruppe und einem C₁- bis C₄-Alkylenrest,
R⁵ ist H oder C₁- bis C₆-Alkyl,
X ist Si oder Sn,
Y ist O oder NH;
- eine bei Bestrahlung eine Säure freisetzende strahlungsempfindliche Verbindung;
- ein Lösemittel;
- gegebenenfalls Additive.

2. Strahlungsempfindliches Gemisch nach Anspruch 1, **dadurch gekennzeichnet, daß** die strahlungsempfindliche Verbindung eine ionische Verbindung, insbesondere ein Oniumsalz, oder eine nicht-ionische Verbindung, insbesondere ein Imidsulfonsäureester, ist.

3. Verwendung des strahlungsempfindlichen Gemisches nach Anspruch 1 oder 2 zur Herstellung von positiven oder negativen Reliefstrukturen.

## Claims

1. A radiation-sensitive composition containing the following components:
- a film-forming polymer having an acid-labile, hydrolysis-stable polymeric component (A) with the following structure: 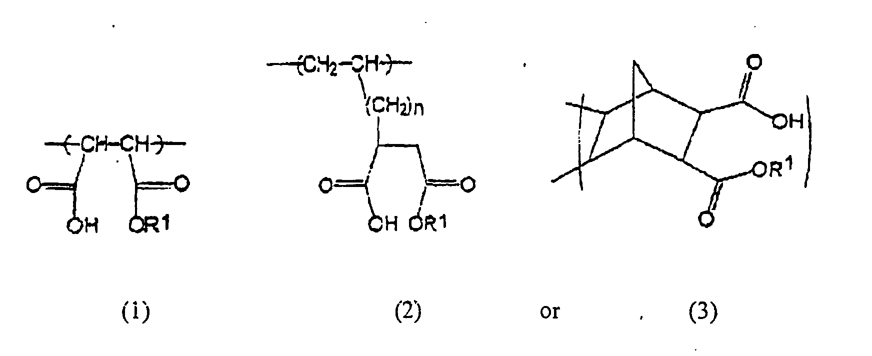 in a proportion of 1 to 99 mol-%, and a thermally-stable polymeric component (B) with the following structure: 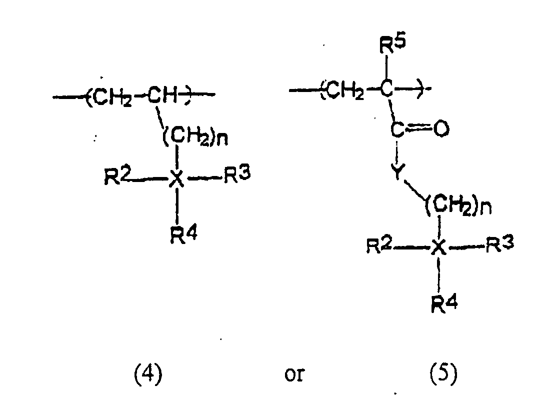 in a proportion of 99 to 1 mol-%,
wherein:
n = 0, 1, 2 or 3; for structure (5), n = 1, 2 or 3,
R¹ is a hydrocarbon residue with a total of 4 to 10 C atoms, which is bound to the O atom via a tertiary C atom, or a 2-tetrahydrofuranyl or 2-tetrahydropyranyl residue,
R², R³ and R⁴ are - independently of one another - C₁- to C₆-alkyl or C₁- to C₆-alkoxy, C₆- to C₁₈-aryl or C₆- to C₁₈-aryloxy or aralkyl with a C₆- to C₁₈-aryl group and a C₁- to C₄-alkylene residue,
R⁵ is H or C₁- to C₆-alkyl,
X is Si or Sn,
Y is O or NH;
- a radiation-sensitive compound which releases an acid when irradiated;
- a solvent;
- additives as required.

2. A radiation-sensitive composition according to Claim 1, **characterised in that** the radiation-sensitive composition is an ionic compound, in particular an onium salt, or a non-ionic compound, in particular an imidosulfonic acid ester.

3. Use of the radiation-sensitive composition according to Claim 1 or 2 for the preparation of positive or negative relief structures.

## Revendications

1. Mélange photosensible qui contient les composants suivants :
- polymère formant un film, qui présente une structure polymère stable d'un point de vue hydrolytique et instable d'un point de vue acide (A) de structure suivante : 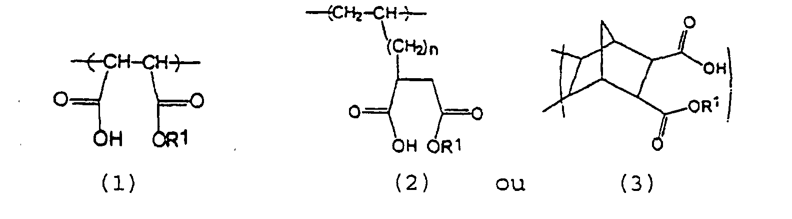 avec une portion de 1 à 99 % molaire et une structure polymère stable d'un point de vue thermique (B) : 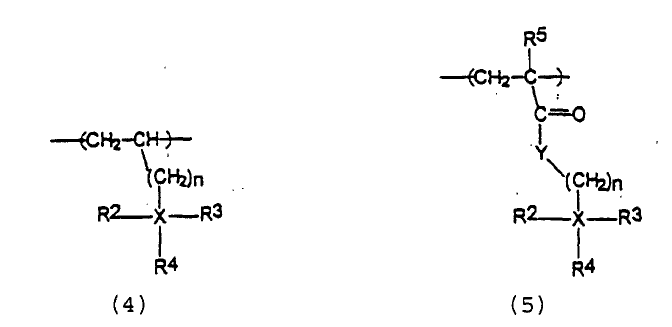 présentant une proportion de 99 à 1 % molaire, où ce qui suit prévaut :
n = 0, 1, 2 ou 3, dans laquelle pour la structure (5) n = 1, 2 ou 3
R¹ est un reste d'hydrocarbure lié au moyen d'un atome de carbone tertiaire à un atome d'oxygène avec au total 4 à 10 atomes de carbone ou un reste de 2-tétrahydropyranyle ou 2-hydrofuranyle, R², R³ et R⁴ sont, indépendamment l'un de l'autre, un alkyle en C₁-C₆ ou un alcoxy en C₁-C₆, un aryle en C₁-C₁₈ ou un aryloxy en C₆-C₁₈ ou un aralkyle comprenant un groupe aryle en C₆-C₁₈ et un groupe alcylène en C₁-C₄,
R⁵ est H ou un alkyle en C₁-C₆,
X est Si ou Sn,
Y est O ou NH ;
- un composé photosensible libérant un acide lors de l'exposition à la lumière ;
- un solvant ;
- le cas échéant des additifs.

2. Mélange photosensible selon la revendication 1,
**caractérisé en ce que**
le composé photosensible est un composé ionique notamment un sel d'onium ou un composé non ionique en particulier un ester d'acide imide sulfonique.

3. Utilisation du mélange photosensible selon la revendication 1 ou 2 pour la production de structure négative ou positive à relief.
